# EUROPEAN PATENT APPLICATION

(11) **EP 4 604 688 A1**
(43) Date of publication of application: **20.08.2025**
(21) Application number: 25151729.8
(22) Date of filing: 14.01.2025
(51) Int. Cl.: H10D 30/66, H10D 64/27, H10D 62/10

(54) **POWER SEMICONDUCTOR DEVICE INCLUDING GATE WITH IMPROVED RELIABILITY**

(30) Priority: 13.02.2024 KR 20240020545
(71) Applicant: Hyundai Mobis Co., Ltd., Gangnam-gu Seoul 06141 (KR)
(72) Inventor: LEE, Ju Hwan, 16891 Yongin-si (KR); KIM, Tae Yang, 16891 Yongin-si (KR); KIM, Sin A, 16891 Yongin-si (KR); HA, Jeong Mok, 16891 Yongin-si (KR); KANG, Min Gi, 16891 Yongin-si (KR); WOO, Hyuk, 16891 Yongin-si (KR); HWANG, Jun Ha, 16891 Yongin-si (KR)
(74) Representative: Vossius & Partner Patentanwälte Rechtsanwälte mbB

(57) **Abstract**

A power semiconductor device including a first gate electrode layer recessed into a semiconductor substrate, the first gate electrode layer being configured to extend in a first direction for a first length and a second gate electrode layer configured to extend in the first direction on a surface of the semiconductor substrate, the second gate electrode layer having a second length shorter than the first length, and configured to contact a first side surface of the first gate electrode layer.

## Description

### CROSS-REFERENCE TO RELATED APPLICATION

This application claims the benefit of Korean Patent Application No. 10-2024-0020545, filed in the Korean Intellectual Property Office on February 13, 2024.

### 1. Field

The present disclosure relates to a power semiconductor device and, more particularly, to a power semiconductor device including a gate with improved reliability.

### 2. Description of the Related Art

A power semiconductor device is a semiconductor device that operates in a highvoltage and high-current environment. The power semiconductor device may be used in a field requiring high power switching, such as an inverter. Examples of transistors that may be used as the power semiconductor device include an insulated gate bipolar transistor (IGBT) and a power metal-oxide semiconductor field effect transistor (MOSFET), etc.

The power semiconductor device may include a gate, and the gate may include an insulating layer. The power semiconductor device may operate when a voltage greater than a threshold voltage is applied to the gate, and may not operate when a voltage less than the threshold voltage is applied to the gate. Research is actively being conducted to improve the reliability of the operation of the power semiconductor device.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter. In a general aspect, here is provided a power semiconductor device including a first gate electrode layer recessed into a semiconductor substrate, the first gate electrode layer being configured to extend in a first direction for a first length and a second gate electrode layer configured to extend in the first direction on a surface of the semiconductor substrate, the second gate electrode layer having a second length shorter than the first length, and configured to contact a first side surface of the first gate electrode layer.

The power semiconductor device may include an intermediate insulating layer configured to contact the first side surface of the first gate electrode layer and to contact a second side surface of the second gate electrode layer.

The power semiconductor device may include a bottom insulating layer disposed under the first gate electrode layer, the second gate electrode layer, and the intermediate insulating layer.

The power semiconductor device may include a top insulating layer disposed on the first gate electrode layer, the second gate electrode layer, and the intermediate insulating layer.

The top insulating layer may be configured to contact one or more of another first side surface of the first gate electrode layer and another second side surface of the second gate electrode layer.

The power semiconductor device may include a source electrode layer disposed on the top insulating layer and configured to contact a third side surface of the top insulating layer.

The power semiconductor device may include a source region disposed on the surface of the semiconductor substrate inside the semiconductor substrate, the source region being configured to contact the bottom insulating layer, and including a first conductive type impurity and a body region configured to contact a lower surface of the source region, and to contact a lower surface of the bottom insulating layer, and including a second conductive type impurity.

The power semiconductor device may include a drift region disposed under the body region inside the semiconductor substrate and including the first conductive type impurity and a drain electrode layer disposed under the drift region.

The first gate electrode layer may include one or more of poly-silicon, doped poly-silicon, a metal, a metal nitride, and a metal silicide, the second gate electrode layer may include a second material identical to a first material of the first gate electrode layer, and the intermediate insulating layer may include one or more of silicon oxide, silicon nitride, germanium oxide, germanium nitride, hafnium oxide, zirconium oxide, and aluminum oxide.

The semiconductor substrate may include a third material having a third band gap greater than a first band gap of silicon.

In a general aspect, here is provided a power semiconductor device including a planar gate electrode layer including first gate regions extending in a first direction on a surface of a semiconductor substrate, the first gate regions being respectively configured to be spaced apart from each other in a second direction and second gate regions disposed between the first gate regions on the surface of the semiconductor substrate, the second gate regions being respectively configured to be spaced apart from each other in the first direction, and a trench gate electrode layer including third gate regions extending from the first gate regions, respectively, into an interior of the semiconductor substrate.

The power semiconductor device may include an intermediate insulating layer configured to be surrounded by the first gate regions and the second gate regions on the surface of the semiconductor substrate.

The power semiconductor device may include a bottom insulating layer disposed under each of the second gate regions and each of the third gate regions.

The power semiconductor device may include a top insulating layer disposed on each of the first gate regions, each of the second gate regions, and the intermediate insulating layer.

The top insulating layer may be configured to contact a first side surface of the first gate region and a second side surface of the second gate region.

The power semiconductor device may include a source electrode layer disposed on the top insulating layer which may be configured to contact a third side surface of the top insulating layer.

The power semiconductor device may include a source region disposed on the surface of the semiconductor substrate inside the semiconductor substrate, the source region being configured to contact the bottom insulating layer, and including a first conductive type impurity and a body region configured to contact a lower surface of the source region, to contact a lower surface of the bottom insulating layer, and including a second conductive type impurity.

The power semiconductor device may include a drift region disposed under the body region inside the semiconductor substrate and including the first conductive type impurity and a drain electrode layer disposed under the drift region.

The planar gate electrode layer may include one or more of poly-silicon, doped poly-silicon, a metal, a metal nitride, and a metal silicide, the trench gate electrode layer may include a first material identical to a second material of the planar gate electrode layer, and the intermediate insulating layer may include one or more of silicon oxide, silicon nitride, germanium oxide, germanium nitride, hafnium oxide, zirconium oxide, and aluminum oxide.

The semiconductor substrate may include a third material having a third band gap greater than a first band gap of silicon.

### BRIEF DESCRIPTION OF THE DRAWINGS

The above and other objects, features and advantages of the present disclosure will be more apparent from the following detailed description taken in conjunction with the accompanying drawings:
FIG. 1 is a perspective view illustrating a portion of a power semiconductor device according to an embodiment of the present disclosure;
FIG. 2 is a perspective view illustrating a gate electrode layer of the power semiconductor device of FIG. 1;
FIG. 3 is a cross-sectional view illustrating a surface taken along line A-A' of the power semiconductor device of FIG. 1;
FIG. 4 is a cross-sectional view illustrating a surface taken along line B-B' of a first cross-section of FIG. 3;
FIG. 5 is a cross-sectional view illustrating a surface taken along line C-C' of the first cross-section of FIG. 3;
FIG. 6 is a cross-sectional view illustrating a surface taken along line D-D' of the first cross-section of FIG. 3; and
FIG. 7 is a cross-sectional view illustrating a surface taken along line E-E' of the first cross-section of FIG. 3.

Throughout the drawings and the detailed description, unless otherwise described or provided, the same, or like, drawing reference numerals may be understood to refer to the same, or like, elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Advantages and features of the present disclosure and methods of achieving the advantages and features will be clear with reference to embodiments described in detail below together with the accompanying drawings. However, the present disclosure is not limited to the embodiments disclosed herein but will be implemented in various forms. The embodiments of the present disclosure are provided so that the present disclosure is completely disclosed, and a person with ordinary skill in the art can fully understand the scope of the present disclosure. The present disclosure will be defined only by the scope of the appended claims. Meanwhile, the terms used in the present specification are for explaining the embodiments, not for limiting the present disclosure.

Terms, such as first, second, A, B, (a), (b) or the like, may be used herein to describe components. Each of these terminologies is not used to define an essence, order or sequence of a corresponding component but used merely to distinguish the corresponding component from other components). For example, a first component may be referred to as a second component, and similarly the second component may also be referred to as the first component.

Throughout the specification, when a component is described as being "connected to," or "coupled to" another component, it may be directly "connected to," or "coupled to" the other component, or there may be one or more other components intervening therebetween. In contrast, when an element is described as being "directly connected to," or "directly coupled to" another element, there can be no other elements intervening therebetween.

In a description of the embodiment, in a case in which any one element is described as being formed on or under another element, such a description includes both a case in which the two elements are formed in direct contact with each other and a case in which the two elements are in indirect contact with each other with one or more other elements interposed between the two elements. In addition, when one element is described as being formed on or under another element, such a description may include a case in which the one element is formed at an upper side or a lower side with respect to another element.

The singular forms "a", "an", and "the" are intended to include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof.

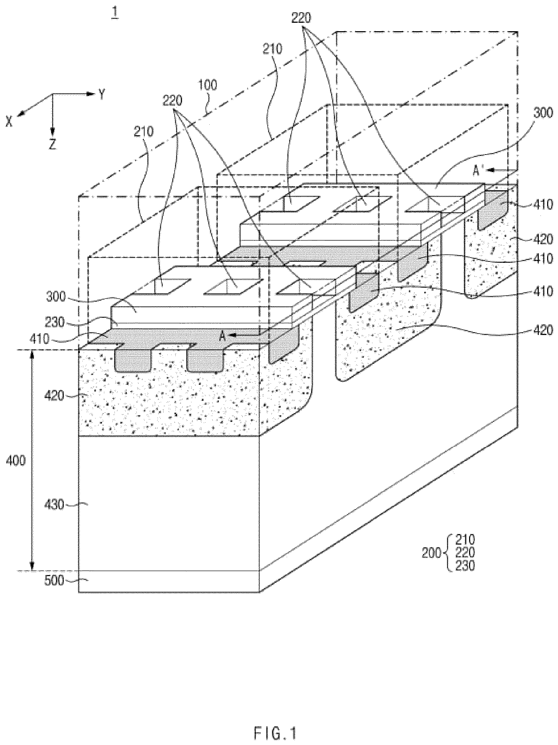

FIG. 1 is a perspective view illustrating a portion of a power semiconductor device 1 according to an embodiment of the present disclosure.

Referring to FIG. 1, the power semiconductor device 1 may include a source electrode layer 100, a gate insulating layer 200, a gate electrode layer 300, a semiconductor substrate 400, and a drain electrode layer 500.

The source electrode layer 100 may be disposed on the gate insulating layer 200. The source electrode layer 100 may be a region to which a source voltage is applied. The source electrode layer 100 may include a conductive material, for example, at least one of poly-silicon, doped poly-silicon, a metal, a metal nitride, a metal silicide, or a combination thereof. The source voltage applied to the source electrode layer 100 may be applied to a source region 410.

The gate insulating layer 200 may include a top insulating layer 210, an intermediate insulating layer 220, and a bottom insulating layer 230. The top insulating layer 210 may be disposed on the intermediate insulating layer 220. The intermediate insulating layer 220 may be disposed on the bottom insulating layer 230. Each of the top insulating layer 210, the intermediate insulating layer 220, and the bottom insulating layer 230 may include an insulating material, for example, at least one of silicon oxide, silicon nitride, germanium oxide, germanium nitride, hafnium oxide, zirconium oxide, aluminum oxide, and a combination thereof. Each of the top insulating layer 210, the intermediate insulating layer 220, and the bottom insulating layer 230 may be composed of the same material.

The top insulating layer 210 may electrically separate the source electrode layer 100 from the gate electrode layer 300. The intermediate insulating layer 220 may reduce stress that may occur inside the gate electrode layer 300. The bottom insulating layer 230 may electrically separate the gate electrode layer 300 from the semiconductor substrate 400.

The gate electrode layer 300 may be a region to which a gate voltage is applied. When difference between the gate voltage and the source voltage is greater than or equal to a threshold voltage of the power semiconductor device 1, the power semiconductor device 1 may be in an on-state. When the difference between the gate voltage and the source voltage is less than the threshold voltage of the power semiconductor device 1, the power semiconductor device 1 may be in an off-state. When the power semiconductor device 1 is in the on-state, unlike the off-state, a current flows inside the semiconductor substrate 400 and the power semiconductor device 1 may operate.

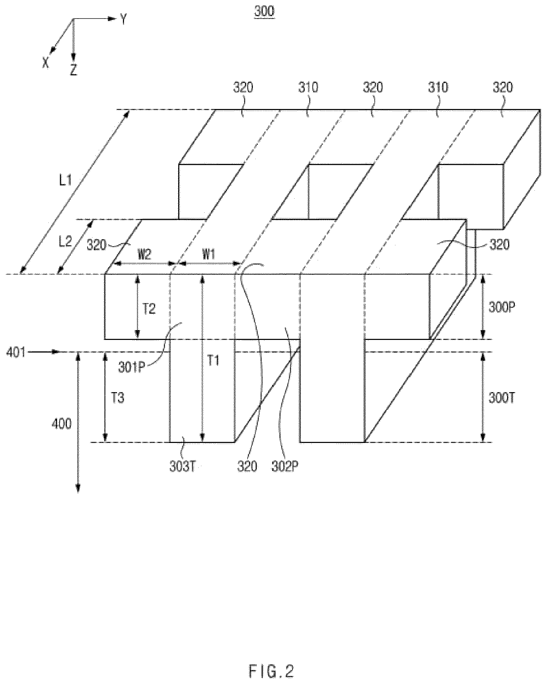

The gate electrode layer 300 may include a conductive material, for example, at least one of poly-silicon, doped poly-silicon, a metal, a metal nitride, a metal silicide, or a combination thereof. A more detailed description of the structure of the gate electrode layer 300 will be made with reference to FIG. 2.

The semiconductor substrate 400 may include the source region 410, a body region 420, and a drift region 430. The semiconductor substrate 400 may include a material having a larger band gap (e.g., silicon carbide (SiC), gallium nitride (GaN), etc.) than silicon.

The source region 410 may be a region including an impurity of a first conductive type (e.g., an N type). The source region 410 may be a region in contact with the source electrode layer 100 and to which a source voltage is applied by the source electrode layer 100. The source region 410 may be disposed on the upper part of the semiconductor substrate 400.

The body region 420 may be a region including an impurity of a second conductive type (e.g., a P type) opposite to the first conductive type. The body region 420 may be in contact with the side surface and lower surface of the source region 410. The body region 420 may form a channel that allows a current to flow between the drift region 430 and the source region 410 when the power semiconductor device 1 is in the on-state. The channel may be formed, for example, in a vertical direction "Z".

The drift region 430 may be a region including a first conductive type impurity. The concentration of the first conductive type impurity in the drift region 430 may be lower than the concentration of the first conductive type impurity in the source region 410.

The drain electrode layer 500 may be disposed under the semiconductor substrate 400. The drain electrode layer 500 may be a region to which a drain voltage (e.g., a ground voltage) is applied. The drain electrode layer 500 may include a conductive material, for example, at least one of poly-silicon, doped poly-silicon, a metal, a metal nitride, a metal silicide, or a combination thereof.

FIG. 2 is a perspective view illustrating the gate electrode layer 300 of the power semiconductor device 1 of FIG. 1.

Referring to FIG. 2, the gate electrode layer 300 may, for example, include a first gate electrode layer 310 and a second gate electrode layer 320. Each of the first gate electrode layer 310 and the second gate electrode layer 320 may include the same material. The gate electrode layer 300 may, for another example, include a planar gate electrode layer 300P and a trench gate electrode layer 300T. Each of the planar gate electrode layer 300P and the trench gate electrode layer 300T may include the same material.

Referring to FIGS. 1 and 2, in the gate electrode layer 300 according to an embodiment of the present disclosure, the first gate electrode layer 310 may be recessed into the interior of the semiconductor substrate 400 and extend in a first direction "X", and may have a first length L1 in the first direction "X". The first gate electrode layer 310 may have a first width W1 in a second direction "Y". The first gate electrode layer 310 may have a first thickness T1 in the third direction "Z". A portion of the first gate electrode layer 310 recessed into the interior of the semiconductor substrate 400 may be a portion located under a surface 401 of the semiconductor substrate 400. The first gate electrode layer 310 may have, for example, a rectangular parallelepiped shape, but is not limited thereto. For example, the first gate electrode layer 310 may have rounded shapes in edges or vertices thereof. When the edges or vertices of the first gate electrode layer 310 within the semiconductor substrate 400 have rounded shapes, the phenomenon of electric fields being concentrated on a portion around the first gate electrode layer 310 within the semiconductor substrate 400 may be alleviated.

The first gate electrode layer 310 may include a plurality of first gate electrode layers arranged. The first gate electrode layers 310 may be disposed in the second direction "Y" by being spaced apart from each other.

The second gate electrode layer 320 may extend in the first direction "X" on the surface 401 of the semiconductor substrate 400 and may have a second length L2 shorter than the first length L1 in the first direction "X". The second gate electrode layer 320 may be in contact with the side surface of the first gate electrode layer 310. The second gate electrode layer 320 may have a second width W2 in the second direction "Y". The second width W2 may be the same as or different from the first width W1 depending on an embodiment. The second gate electrode layer 320 may have a second thickness T2 in the third direction "Z". The second thickness T2 may be smaller than the first thickness T1. The second gate electrode layer 320 may have, for example, a rectangular parallelepiped shape, but is not limited thereto.

The second gate electrode layer 320 may include a plurality of second gate electrode layers arranged. The second gate electrode layers 320 may be disposed in the first direction "X" by being spaced apart from each other. The second gate electrode layers 320 may be disposed between adjacent first gate electrode layers 310. For example, a first side surface of the second gate electrode layer 320 may be in contact with the first gate electrode layer 310, and a second side surface of the second gate electrode layer 320 facing the first side surface of the second gate electrode layer 320 may be in contact with a first side surface of a first gate electrode layer 310 adjacent to the first gate electrode layer 310. For example, the first gate electrode layers 310 and the second gate electrode layers 320 may have a ladder shape when viewed in the third direction "Z".

The second gate electrode layers 320 may be disposed even in the second direction "Y" by being spaced apart from each other. The second gate electrode layers 320 may be disposed between the plurality of first gate electrode layers 310 that are spaced apart from each other.

In the gate electrode layer 300 according to an embodiment of the present disclosure, the planar gate electrode layer 300P may be disposed on the surface 401 of the semiconductor substrate 400. The planar gate electrode layer 300P may include first gate regions 301P extending in the first direction "X" and spaced apart from each other in the second direction "Y", and second gate regions 302P disposed between the first gate regions 301P and spaced apart from each other in the first direction "X".

The trench gate electrode layer 300T may include third gate regions 303T protruding in the third direction "Z" from the planar gate electrode layer 300P.

Each of the first gate regions 301P may be a region in which the first gate electrode layer 310 and the planar gate electrode layer 300P overlap. The second gate region 302P may be a region in which the second gate electrode layer 320 and the planar gate electrode layer 300P overlap. According to an embodiment, the second gate region 302P and the second gate electrode layer 320 may be substantially an identical region. The third gate region 303T may refer to a region protruding in the third direction "Z" in the first gate electrode layer 310. Each of the first to third gate regions 301P, 302P, and 303T is illustrated with a separate reference numeral for convenience of description of the structure of the gate electrode layer 300.

The first gate region 301P may have the first length L1 in the first direction "X". The first gate region 301P may have the first width W1 in the second direction "Y". The first gate region 301P may have the second thickness T2 in the third direction "Z".

The second gate region 302P may have the second length L2 in the first direction "X". The second gate region 302P may have the second width W2 in the second direction "Y". The second gate region 302P may have the second thickness T2 in the third direction "Z".

The third gate region 303T may have the first length L1 in the first direction "X". The third gate region 303T may have the first width W1 in the second direction "Y". According to another embodiment, the third gate region 303T may have a width smaller than the first width W1 in the second direction "Y". The third gate region 303T may have a third thickness T3 in the third direction "Z". The third thickness T3 may, for example, be equal to difference between the first thickness T1 and the second thickness T2, but may vary due to variables or limitations of a process.

The planar gate electrode layer 300P may include a structure in which the first gate region 301P and the second gate region 302P are alternately arranged along the second direction "Y" while in contact with each other. For example, the planar gate electrode layer 300P may have a ladder shape.

The trench gate electrode layer 300T may include a structure in which the third gate regions 303T are arranged to be spaced apart from each other at a predetermined interval along the second direction "Y". The predetermined interval may be, for example, the second width W2. The third gate region 303T may overlap or be aligned with the first gate region 301P in the third direction "Z".

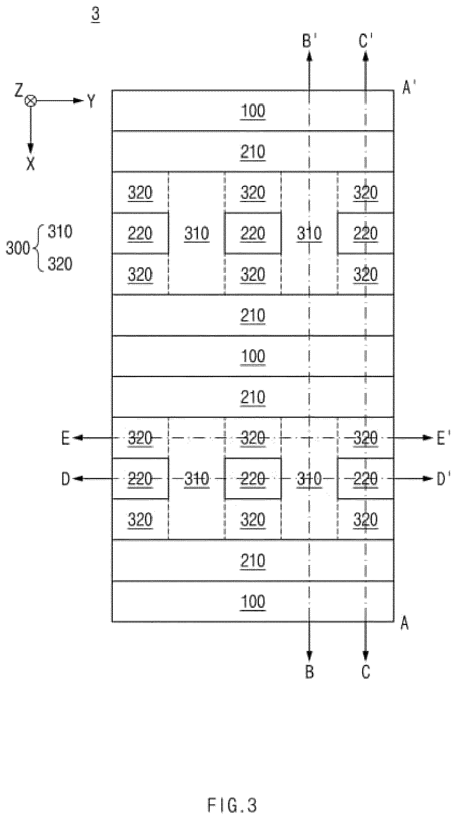

FIG. 3 is a cross-sectional view illustrating a surface taken along line A-A' of the power semiconductor device 1 of FIG. 1.

Referring to FIGS. 1 and 3, a first cross-section 3 may be an embodiment of a cross-section taken along line A-A' of the power semiconductor device 1. The first cross-section 3 may include the source electrode layer 100, the top insulating layer 210, the intermediate insulating layer 220, the first gate electrode layer 310, and the second gate electrode layer 320. Any description that overlaps the description of FIG. 1 will be omitted.

A side on which the source electrode layer 100 and the top insulating layer 210 are in contact with each other may be a side surface of the top insulating layer 210.

A surface on which the top insulating layer 210 and the gate electrode layer 300 are in contact with each other may be a side surface of the gate electrode layer 300.

The intermediate insulating layer 220 may be surrounded by the first gate electrode layers 310 and the second gate electrode layers 320. The first gate electrode layer 310 illustrated in FIG. 3 may be a region corresponding to the first gate region 301P of FIG. 2. The second gate electrode layer 320 illustrated in FIG. 3 may be a region corresponding to the second gate region 302P of FIG. 2. The intermediate insulating layer 220 may be in contact with one side surface of the first gate electrode layer 310 and may be in contact with one side surface of the second gate electrode layer 320.

When a strong electric field or current occurs inside the power semiconductor device 1, stress may occur at the center of the gate electrode layer 300. When stress occurs in the gate electrode layer 300, the performance of the gate electrode layer 300 may deteriorate and the reliability of the power semiconductor device 1 may deteriorate.

When the intermediate insulating layer 220 is disposed at the center of the gate electrode layer 300, the stress at the center is distributed, which reduces performance degradation of the gate electrode layer 300 and improves the reliability of the power semiconductor device 1.

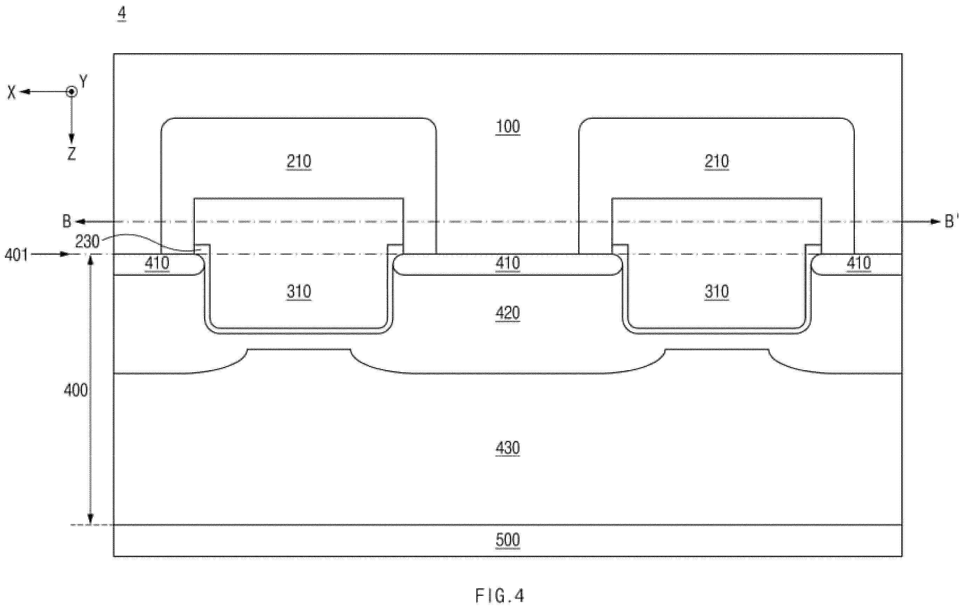

In FIGS. 4 to 7 below, contents that overlap contents described in FIGS. 1 to 3 will be omitted.

FIG. 4 is a cross-sectional view illustrating a surface taken along line B-B' of the first cross-section 3 of FIG. 3.

Referring to FIGS. 1 to 4, a second cross-section 4 may be an embodiment of a cross-section taken along line B-B' of the first cross-section 3. The second cross-section 4 may include the source electrode layer 100, the top insulating layer 210, the first gate electrode layer 310, the semiconductor substrate 400, and the drain electrode layer 500.

The source electrode layer 100 may be disposed on the top insulating layer 210. For example, the source electrode layer 100 may be in contact with the upper surface of the top insulating layer 210. The source electrode layer 100 may extend in the second direction "Y". The source electrode layer 100 may further extend along the third direction "Z" into space between two adjacent top insulating layers 210. For example, the source electrode layer 100 may be in contact with one side surface of the top insulating layer 210. The source electrode layer 100 may be in contact with the surface 401 of the semiconductor substrate 400 and may be in contact with the source region 410.

The top insulating layer 210 may be disposed on the first gate electrode layer 310. For example, the top insulating layer 210 may be in contact with the upper surface of the first gate electrode layer 310. The top insulating layer 210 may be in contact with the side surface of the first gate electrode layer 310.

The first gate electrode layer 310 may be surrounded by the top insulating layer 210 and the bottom insulating layer 230.

The bottom insulating layer 230 may surround a trench structure of the first gate electrode layer 310 recessed into the semiconductor substrate 400. For example, the bottom insulating layer 230 may be in contact with the lower surface and the side surface of the first gate electrode layer 310. The bottom insulating layer 230 may be in contact with the top insulating layer 210 on the surface 401 of the semiconductor substrate 400.

The semiconductor substrate 400 may include the source region 410, the body region 420, and the drift region 430.

The source region 410 may be disposed in a lateral direction (e.g., the first direction "X") of the trench structure of the first gate electrode layer 310. For example, the source region 410 may be disposed on opposite sides of the first gate electrode layer 310. The source region 410 may be disposed on the surface 401 of the semiconductor substrate 400. The side surface of the source region 410 may be in contact with the bottom insulating layer 230. The upper surface of the source region 410 may be in contact with the top insulating layer 210 and the source electrode layer 100.

The body region 420 may be disposed under the source region 410 and the bottom insulating layer 230. For example, the body region 420 may be in contact with the lower surface and/or the side surface of the source region 410. The body region 420 may be in contact with the lower surface and the side surface of the bottom insulating layer 230. The body region 420 may be formed to be deep under the source region 410 than under the bottom insulating layer 230. Depth comparison may be determined based on the surface 401 of the semiconductor substrate 400.

The drift region 430 may be disposed under the body region 420. For example, the drift region 430 may be in contact with the lower surface of the body region 420.

The drain electrode layer 500 may be disposed under the drift region 430. For example, the drain electrode layer 500 may be in contact with the lower surface of the drift region 430.

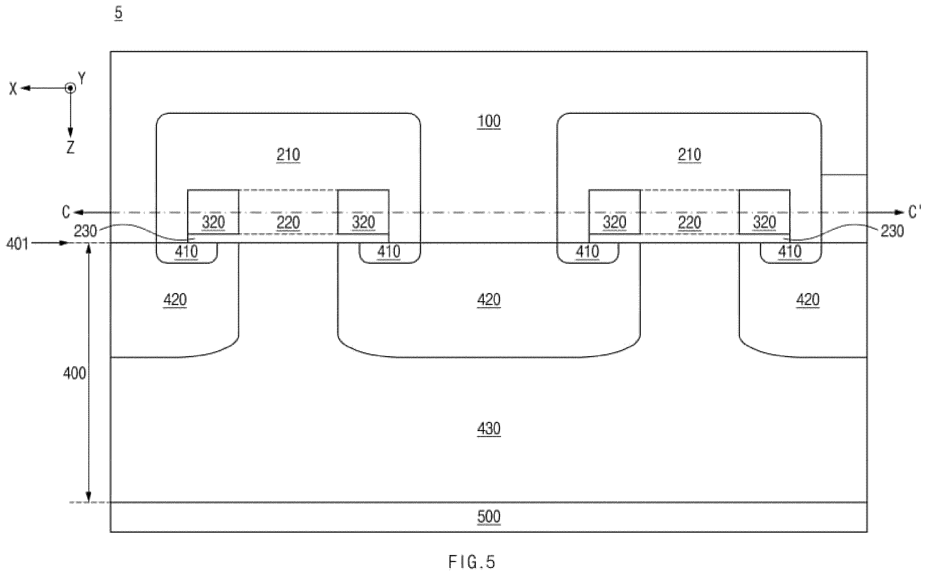

FIG. 5 is a cross-sectional view illustrating a surface taken along line C-C' of the first cross-section 3 of FIG. 3.

Referring to FIGS. 1, 2, 3, and 5, a third cross-section 5 may be an embodiment of a cross-section taken along line C-C' of the first cross-section 3. The third cross-section 5 may include the source electrode layer 100, the top insulating layer 210, the intermediate insulating layer 220, the bottom insulating layer 230, the second gate electrode layer 320, the source region 410, the body region 420, the drift region 430, and the drain electrode layer 500.

The intermediate insulating layer 220 may be disposed between the top insulating layer 210 and the bottom insulating layer 230. For example, the intermediate insulating layer 220 may be in contact with the lower surface of the top insulating layer 210, and may be in contact with the upper surface of the bottom insulating layer 230.

The second gate electrode layer 320 may be surrounded by the top insulating layer 210, the intermediate insulating layer 220, and the bottom insulating layer 230. For example, the upper surface of the second gate electrode layer 320 may be in contact with the top insulating layer 210. A first side surface of the second gate electrode layer 320 may be in contact with the intermediate insulating layer 220, and a second side surface thereof may be in contact with the top insulating layer 210. The lower surface of the second gate electrode layer 320 may be in contact with the bottom insulating layer 230.

The source region 410 may be in contact with the top insulating layer 210 and the bottom insulating layer 230. The source region 410 may overlap the second gate electrode layer 320 when viewed in the third direction "Z".

The drift region 430 may include a vertical region of the drift region 430 in contact with the surface 401 of the semiconductor substrate 400 in at least a portion of a region in which the drift region 430 overlaps the intermediate insulating layer 220 when the drift region 430 is viewed in the third direction "Z". The vertical region may be in contact with the side surface of the body region 420.

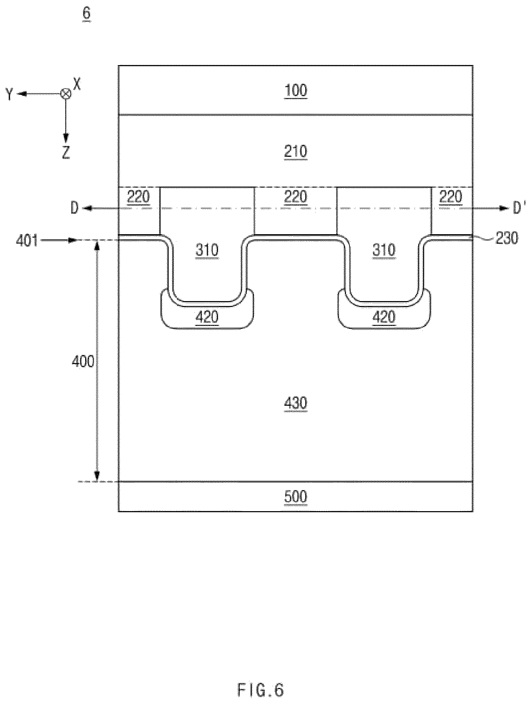

FIG. 6 is a cross-sectional view illustrating a surface taken along line D-D' of the first cross-section 3 of FIG. 3.

Referring to FIGS. 1, 2, 3, and 6, a fourth cross-section 6 may be an embodiment of a cross-section taken along line D-D' of the first cross-section 3. The fourth cross-section 6 may include the source electrode layer 100, the top insulating layer 210, the intermediate insulating layer 220, the bottom insulating layer 230, the first gate electrode layer 310, the semiconductor substrate 400, and the drain electrode layer 500.

The first gate electrode layer 310 and the intermediate insulating layer 220 may be alternately arranged along the second direction "Y" on the surface 401 of the semiconductor substrate 400.

According to an embodiment, the first gate electrode layer 310 may have a width in the second direction "Y" on the surface 401 of the semiconductor substrate 400 greater than a width in the second direction "Y" under the surface 401 of the semiconductor substrate 400.

The bottom insulating layer 230 may be disposed along the side surface and the lower surface of the first gate electrode layer 310. The bottom insulating layer 230 may be further disposed along the surface 401 of the semiconductor substrate 400.

The semiconductor substrate 400 may include the body region 420 and the drift region 430.

The body region 420 may be disposed under the first gate electrode layer 310. For example, the body region 420 may be in contact with the bottom insulating layer 230, which is in contact with the lower surface of the first gate electrode layer 310.

The drift region 430 may be in contact with the lower surface and the side surface of the body region 420. The drift region 430 may extend to the surface 401 of the semiconductor substrate 400 between the first gate electrode layers 310.

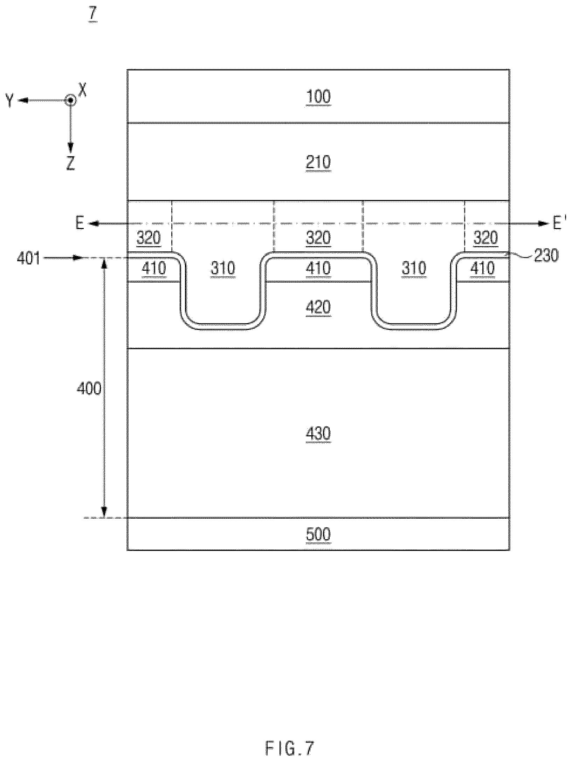

FIG. 7 is a cross-sectional view illustrating a surface taken along line E-E' of the first cross-section 3 of FIG. 3.

Referring to FIGS. 1, 2, 3, and 7, a fifth cross-section 7 may be an embodiment of a cross-section taken along line E-E' of the first cross-section 3. The fifth cross-section 7 may include the source electrode layer 100, the top insulating layer 210, the bottom insulating layer 230, the first gate electrode layer 310, the second gate electrode layer 320, the semiconductor substrate 400, and the drain electrode layer 500.

The top insulating layer 210 may be disposed on the first gate electrode layer 310 and the second gate electrode layer 320. For example, the top insulating layer 210 may be in contact with the upper surface of the first gate electrode layer 310 and the upper surface of the second gate electrode layer 320.

The bottom insulating layer 230 may be in contact with the lower surface and the side surface of the first gate electrode layer 310 and with the lower surface of the second gate electrode layer 320.

The semiconductor substrate 400 may include the source region 410, the body region 420, and the drift region 430.

The source region 410 may overlap the second gate electrode layer 320 when viewed in the third direction "Z". The source region 410 may be in contact with the surface 401 of the semiconductor substrate 400 and may be disposed between adjacent first gate electrode layers 310.

The embodiments of the present disclosure may provide the power semiconductor device with improved gate reliability.

Various embodiments of the present disclosure do not list all available combinations but are for describing a representative aspect of the present disclosure, and descriptions of various embodiments may be applied independently or may be applied through a combination of two or more.

A number of embodiments have been described above. Nevertheless, it will be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

While this disclosure includes specific examples, it will be apparent after an understanding of the disclosure of this application that various changes in form and details may be made in these examples without departing from the scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is defined not by the detailed description, but by the claims and their equivalents, and all variations within the scope of the claims and their equivalents are to be construed as being included in the disclosure.

## Claims

1. A power semiconductor device, comprising:
a first gate electrode layer recessed into a semiconductor substrate, the first gate electrode layer being configured to extend in a first direction for a first length; and
a second gate electrode layer configured to extend in the first direction on a surface of the semiconductor substrate, the second gate electrode layer having a second length shorter than the first length, and configured to contact a first side surface of the first gate electrode layer.

2. The power semiconductor device of claim 1, further comprising:
an intermediate insulating layer configured to contact the first side surface of the first gate electrode layer and to contact a second side surface of the second gate electrode layer.

3. The power semiconductor device of claim 2, further comprising:
a bottom insulating layer disposed under the first gate electrode layer, the second gate electrode layer, and the intermediate insulating layer.

4. The power semiconductor device of claim 2, further comprising:
a top insulating layer disposed on the first gate electrode layer, the second gate electrode layer, and the intermediate insulating layer.

5. The power semiconductor device of claim 4, wherein the top insulating layer is configured to contact one or more of another first side surface of the first gate electrode layer and another second side surface of the second gate electrode layer.

6. The power semiconductor device of claim 4, further comprising:
a source electrode layer disposed on the top insulating layer and configured to contact a third side surface of the top insulating layer.

7. The power semiconductor device of claim 3, further comprising:
a source region disposed on the surface of the semiconductor substrate inside the semiconductor substrate, the source region being configured to contact the bottom insulating layer, and comprising a first conductive type impurity;
a body region configured to contact a lower surface of the source region, and to contact a lower surface of the bottom insulating layer, and comprising a second conductive type impurity;
a drift region disposed under the body region inside the semiconductor substrate and comprising the first conductive type impurity; and
a drain electrode layer disposed under the drift region.

8. The power semiconductor device of claim 1, wherein the semiconductor substrate comprises a third material having a third band gap greater than a first band gap of silicon.

9. A power semiconductor device, comprising:
a planar gate electrode layer comprising:
first gate regions extending in a first direction on a surface of a semiconductor substrate, the first gate regions being respectively configured to be spaced apart from each other in a second direction; and
second gate regions disposed between the first gate regions on the surface of the semiconductor substrate, the second gate regions being respectively configured
to be spaced apart from each other in the first direction; and
a trench gate electrode layer comprising third gate regions extending from the first gate regions, respectively, into an interior of the semiconductor substrate.

10. The power semiconductor device of claim 11, further comprising:
an intermediate insulating layer configured to be surrounded by the first gate regions and the second gate regions on the surface of the semiconductor substrate.

11. The power semiconductor device of claim 12, further comprising:
a bottom insulating layer disposed under each of the second gate regions and each of the third gate regions.

12. The power semiconductor device of claim 12, further comprising:
a top insulating layer disposed on each of the first gate regions, each of the second gate regions, and the intermediate insulating layer.

13. The power semiconductor device of claim 14, wherein the top insulating layer is configured to contact a first side surface of the first gate region and a second side surface of the second gate region.

14. The power semiconductor device of claim 14, further comprising:
a source electrode layer disposed on the top insulating layer and being configured to contact a third side surface of the top insulating layer.

15. The power semiconductor device of claim 13, further comprising:
a source region disposed on the surface of the semiconductor substrate inside the semiconductor substrate, the source region being configured to contact the bottom insulating layer, and comprising a first conductive type impurity;
a body region configured to contact a lower surface of the source region, to contact a lower surface of the bottom insulating layer, and comprising a second conductive type impurity;
a drift region disposed under the body region inside the semiconductor substrate and comprising the first conductive type impurity; and
a drain electrode layer disposed under the drift region.
